# EUROPEAN PATENT SPECIFICATION

(11) **EP 2 696 382 B1**
(45) Date of publication and mention of the grant of the patent: **07.10.2015**
(21) Application number: 12767390.3
(22) Date of filing: 16.02.2012
(51) Int. Cl.: H01L 41/083, H01L 41/187, H01L 41/27, H01L 41/047

(54) **LAMINATED PIEZOELECTRIC BODY**
LAMINIERTER PIEZOELEKTRISCHER KÖRPER
CORPS PIÉZOÉLECTRIQUE LAMINÉ

(30) Priority: 05.04.2011 JP 2011083763
(43) Date of publication of application: 12.02.2014
(73) Proprietor: Honda Motor Co., Ltd., Minato-ku Tokyo 107-8556 (JP)
(72) Inventor: SUMA, Kazuhiro, Wako-shi Saitama 351-0193 (JP)
(74) Representative: Weickmann & Weickmann
(86) International application number: PCT/JP2012/053624
(87) International publication number: WO 2012/137542

(56) References cited:
- EP-A2- 1 705 722
- EP-A2- 2 043 171
- DE-A1-102004 012 284
- JP-A- 3 270 085
- JP-A- 7 038 168
- JP-A- 7 106 656
- JP-A- 8 250 777
- JP-A- 2003 324 223
- JP-A- 2010 199 271
- JP-U- H0 242 456

## Description

### Technical Field

The present invention relates to a laminated piezoelectric body including a plurality of piezoelectric element segments each including a piezoelectric ceramic having at least one pair of internal electrodes.

### Background Art

A piezoelectric body including a piezoelectric element and an inner electrode disposed alternately is known as disclosed in, for example, patent literature 1 below. The laminated piezoelectric body is driven by applying a voltage from a power supply to the inner electrode. The laminated piezoelectric body driven deforms for use as, for example, an actuator.

There is a laminated piezoelectric body including a plurality of laminated piezoelectric segments each having a pair of inner electrodes within a piezoelectric ceramic. This laminated piezoelectric body is driven by applying a voltage from a power supply to the inner electrode, as is the laminated piezoelectric body of JP 2005-183553 A.

In manufacturing the piezoelectric element segments, the piezoelectric ceramics needs to be fired. In firing the piezoelectric element segments, the piezoelectric ceramics would be distorted. When the distortion occurs in the piezoelectric ceramic, it would be difficult to laminate the piezoelectric element segments together in coaxial relationship. In order to laminate the plurality of piezoelectric element segments together in coaxial relationship, contact portions of adjacent ones of the piezoelectric element segments are ground to flatten in parallel to each other.

However, it is difficult to grind the contact portions of the piezoelectric element segments so as to flatten the contact portions in parallel. In some case, one of a pair of the contact portions contacting each other may be inclined relative to the opposite one. With the one of the contact portions inclined relative to the opposite one, the piezoelectric element segments laminated together would be inclined relative to an axis of the laminated piezoelectric body. As a result, when a voltage is applied to the inner electrodes of the piezoelectric element segments to deform the piezoelectric element segments, it would be difficult to efficiently provide an output generated by the deformation of the piezoelectric element segments.

In order to efficiently provide an output from the piezoelectric element segments, it is suggested that a guide member be used to forcibly laminate the piezoelectric element segments on the axis of the laminated piezoelectric body. However, when the piezoelectric element segments are forcibly laminated using the guide member, a corner of the slanting contact portion would abut on a corner of the adjacent contact portion, in which case a load may be concentrated on the corner of the adjacent contact portion. As a result, it becomes difficult to ensure durability of the piezoelectric element segments.

In order to efficiently provide an output from the piezoelectric element segments, it is suggested that the contact portions of the piezoelectric element segments be accurately ground to flatten in parallel to each other. However, when the contact portions are worked or ground with increased accuracy, a yield rate would be reduced and the grinding operation would be complicated. As a result, it becomes difficult to enhance productivity of the piezoelectric element segments.

DE 10 2004 012 284 A1, on which the preamble of claim 1 is based, teaches that contact portions of piezoelectric element segments adjacent to each other have planar centers.

EP 1 705 722 A2 teaches that a portion of a piezoelectric layer unit and a portion of an adjacent piezoelectric layer unit contact each other, these two contact portions both being planar. More specifically, the contact portion of each unit has a quadrangular pyramid frustum shape having opposite ends beveled. The end has a planar center.

JP 2-42456 U teaches that laminated sub-units contact each other at portions thereof, these two contact portions both being planar.

### SUMMARY OF INVENTION

### Technical Problem

It is an object of the present invention is to provide a laminated piezoelectric body designed to enhance durability and productivity of piezoelectric element segments.

### Solution to Problem

According to one aspect of the present invention, there is provided a laminated piezoelectric body in accordance with claim 1.

The piezoelectric body has a plurality of piezoelectric element segments laminated on one another, each of the piezoelectric element segments comprising: a piezoelectric ceramic; and a pair of internal electrodes disposed in the piezoelectric ceramic in spaced relationship to each other, wherein the internal electrodes are arranged in a direction of lamination of the plurality of piezoelectric element segments in the spaced relationship to each other, the internal electrodes being oriented perpendicularly to the direction of lamination of the plurality of piezoelectric element segments, wherein adjacent ones of the plurality of piezoelectric element segments contact each other at contact portions thereof, and wherein at least one of the contact portions of the adjacent piezoelectric element segments has a triangle-shaped central projection protruding toward an opposite one of the contact portions.

Preferably, as defined in claim 2, the contact portions of the adjacent piezoelectric element segments are joined together by an adhesive agent.

### Advantageous Effects of Invention

As defined in claim 1, the triangle-shaped central projection is formed on the one of the contact portions of the adjacent piezoelectric element segments. Since the central projection can contact a center (i.e., a part other than corners) of the opposite one of the contact portions, a load applied from the central projection to the opposite contact portion can be dispersed to the contact portion in a preferred manner. As a result, it becomes possible to prevent more load than necessary from being applied to the opposite contact portion, thereby enhancing durability of the piezoelectric element segment.

Additionally, the central projection can be formed on the contact portion without increasing working accuracy more than necessary in grinding the contact portion. In other words, it becomes possible to increase a yield rate in grinding the contact portion as well as to facilitate a grinding (working) operation on the contact portion, thereby ensuring productivity of the piezoelectric element segment.

The triangle-shaped surface has a relatively simple configuration. In other words, the central projection is easy to form, thereby further ensuring productivity of the piezoelectric element segment.

As defined in claim 2, the one contact portion and the opposite contact portion are joined together by the adhesive agent. It thus becomes possible to prevent the one contact portion and the opposite contact portion from being displaced in a direction intersecting the direction of the lamination. That is, the plurality of laminated piezoelectric element segments can be held on the axis of the piezoelectric body. Therefore, it becomes possible to, for example, efficiently transmit a load from the one contact portion to the opposite contact portion to thereby enhance reliability of the laminated piezoelectric body.

Since the one contact portion and the opposite contact portion are joined together by the adhesive agent, a rough surface or a recess of the contact portion, if any, can be filled with the adhesive agent to ensure a smooth surface of the contact portion, such that the adjacent contact portions can be easily disposed (laminated) in place on each other. It thus becomes possible to, for example, efficiently transmit a load from the one contact portion to the opposite contact portion to thereby further enhance reliability of the laminated piezoelectric body.

### BRIEF DESCRIPTION OF DRAWINGS

Fig. 1 is a cross-sectional view of a laminated piezoelectric body in a first example, not covered by the claims;
Fig. 2 is a cross-sectional view of selected one of a plurality of piezoelectric element segments shown in Fig. 1;
Fig. 3 is a perspective view of the piezoelectric element segment shown in Fig. 2;
Fig. 4 is a view showing a process for grinding (working) the piezoelectric element segment of Fig. 3;
Fig. 5 is an enlarged view of a region 5 of Fig. 2;
Fig. 6 is a view showing that the piezoelectric element segment in the first example transmits a load to a lower contact portion oriented horizontally;
Fig. 7 is a view showing that the piezoelectric element segment in the first example transmits a load to a lower contact portion slanting;
Fig. 8 is a cross-sectional view of a piezoelectric element segment in a first modification to the first example, not covered by the claims;
Fig. 9 is a cross-sectional view of a piezoelectric element segment in a second modification to the first example, not covered by the claims;
Fig. 10 is a view showing that the piezoelectric element segment in the second modification shown in Fig. 9 transmits a load to a lower contact portion oriented horizontally;
Fig. 11 is a view showing that the piezoelectric element segment in the second modification shown in Fig. 9 transmits a load to a lower contact portion slanting;
Fig. 12 is a cross-sectional view of a piezoelectric element segment in a third modification to the first example, not covered by the claims;
Fig. 13 is a cross-sectional view of a piezoelectric element segment in a fourth modification to the first example, this modification being an embodiment of the invention in accordance with the claims;
Fig. 14 is a cross-sectional view of a laminated piezoelectric body in a second example, not covered by the claims.

### DESCRIPTION OF EXAMPLES AND EMBODIMENT

Certain preferred embodiments of the present invention are described below with reference to the accompanying drawings.

### Example 1

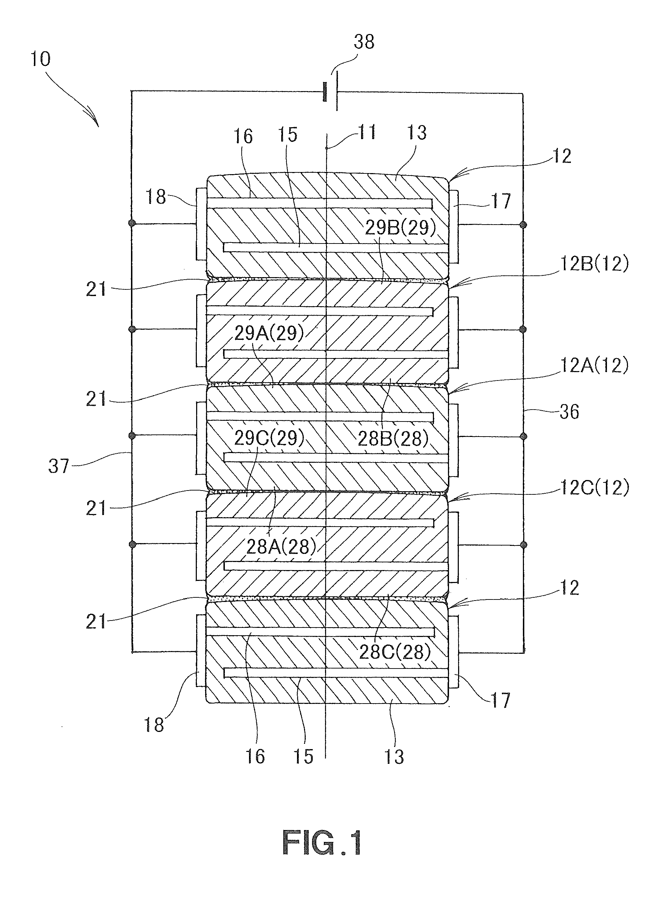

As shown in Fig. 1, a laminated piezoelectric body 10 includes a plurality of piezoelectric element segments (piezoelectric elements) 12 laminated on one another on an axis 11 of the laminated piezoelectric body 10, and an adhesive agent 21 joining adjacent piezoelectric element segments 12 together. The laminated piezoelectric body 10 is used as, for example, an actuator for a machine.

The piezoelectric element segment 12 includes a piezoelectric ceramic 13 of a generally cubic shape, a pair of internal electrodes 15, 16 disposed in the piezoelectric ceramic 13 in spaced relationship to each other, and a pair of external electrodes 17, 18 connected to the internal electrodes 15, 16, respectively.

For facilitating to understand a structure of the laminated piezoelectric body 10, one of the plurality of piezoelectric element segments 12 is selected for discussion as a "piezoelectric element segment 12A". The other piezoelectric element segment 12 adjacent to and laminated on a top of the selected piezoelectric element segment 12A will be hereinafter discussed as an "upper piezoelectric element segment 12B". The other piezoelectric element segment 12 adjacent to and laminated on a bottom of the selected piezoelectric element segment 12A will be hereinafter discussed as a "lower piezoelectric element segment 12C".

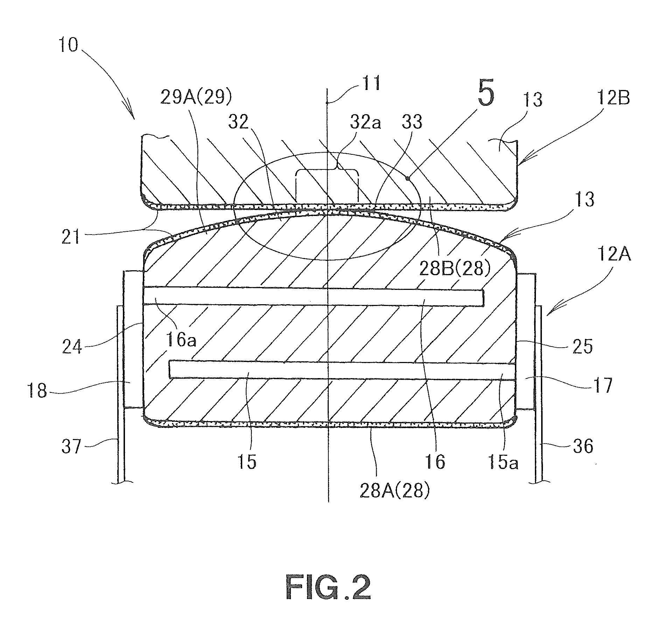

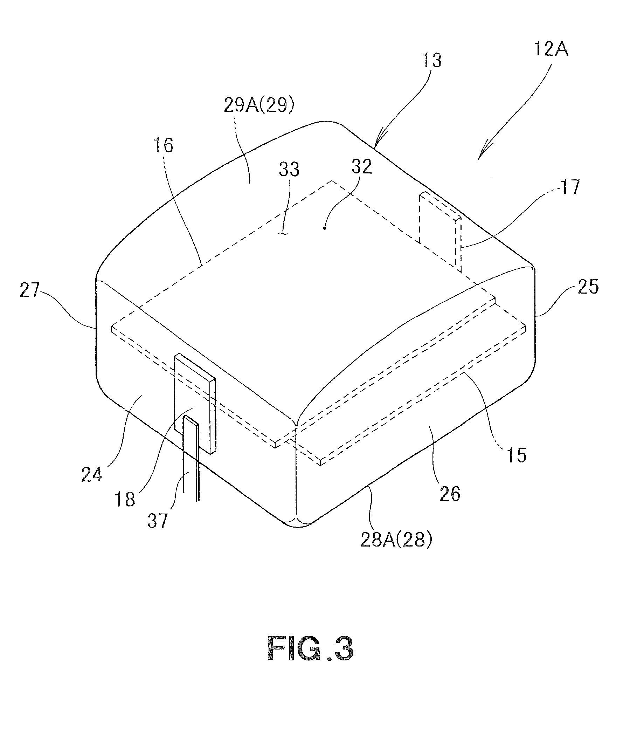

As shown in Fig. 2 and Fig. 3, the piezoelectric ceramic 13 is formed of PZT (lead zirconate titanate [Pb (Zr, Ti)]) material. The piezoelectric ceramic 13 is a generally cubic shape including left and right sidewalls 24, 25, front and rear sidewalls 26, 27, a lower contact portion (contact portion) 28, and an upper contact portion (one contact portion) 29.

As shown in Fig. 1, the lower contact portion 28 and the upper contact portion 29 of the piezoelectric element segment 12A will be hereinafter discussed as a "lower contact portion 28A" and an "upper contact portion 29A", respectively, for the sake of convenience. The lower contact portion 28 and the upper contact portion 29 of the upper piezoelectric element segment 12B will be hereinafter discussed as a "lower contact portion 28B" and an "upper contact portion 29B", respectively, for the sake of convenience. Further, the lower contact portion 28 and the upper contact portion 29 of the lower piezoelectric element segment 12C will be hereinafter discussed as a "lower contact portion 28C" and an "upper contact portion 29C", respectively, for the sake of convenience.

As shown in Fig. 2 and Fig. 3, the left and right sidewalls 24, 25 and the front and rear sidewalls 26, 27 are planar and erected in parallel to the axis 11. The lower contact portion 28A of the piezoelectric element segment 12A contacts the upper contact portion 29C (Fig. 1) of the lower piezoelectric element segment 12C. The lower contact portion 28A is planar and oriented generally perpendicularly to the left and right sidewalls 24, 25 and the front and rear sidewalls 26, 27.

The upper contact portion 29A of the piezoelectric element segment 12A contacts the lower contact portion 28B of the upper piezoelectric element segment 12B. The upper contact portion 29A has a convex shape protruding (rising) upwardly to form a central projection 32 at a center thereof. The central projection 32 has a curved surface 33 protruding upwardly.

Since the central projection 32 is formed at the center of the upper contact portion 29A, the central projection 32 protrudes toward a center of the lower contact portion (an opposite contact portion) 28B of the upper piezoelectric element segment 12B. The central projection 32 contacts the center of the lower contact portion 32. Since the central projection 32 is formed at the center of the upper contact portion 29, the central projection 32 can contact the center of the lower contact portion 28 even where the lower contact portion 28 slants.

The upper contact portion 29A protrudes upwardly in the form of a convexity curved to such a degree that the central projection 32 is relatively flat to contact the lower contact portion 28 of the upper piezoelectric element segment 12B along a relatively large area 32a thereof. Even where the lower contact portion 28 slants, likewise, the central projection 32 contacts the lower contact portion 28 of the upper piezoelectric element segment 12B along a relatively large area 32b thereof.

The central projection 32 can be formed on the upper contact portion 29A without increasing working accuracy more than necessary in grinding the upper contact portion 29A. In other words, it becomes possible to increase a yield rate in grinding the upper contact portion 29A as well as to facilitate a grinding (working) operation on the upper contact portion 29A, thereby ensuring productivity of the piezoelectric element segment 12A.

The central projection 32 has the curved surface 33. The curved surface 33 has a relatively simple shape. Since it is easy to form the central projection 32 to have the simple shape of the curved surface 33, the productivity of the piezoelectric element segment 12A is further ensured.

Although a material of the piezoelectric ceramic 13 is PZT in example 1, the material of the piezoelectric ceramic 13 is not limited to PZT. For example, the material of the piezoelectric ceramic 13 may have a crystal structure of ABC perovskite or tungsten bronze, or may be a bismuth layered ceramic or a layered perovskite-type ceramic.

The ceramic having the crystal structure of ABS perovskite is BaTiO₃, KNbO₃, (K, Na) NbO₃, (K, Na, Li) NbO₃, BiTiO₃ or (Bi, Na)TiO₃ etc.. The ceramic having the crystal structure of tungsten bronze is KSr₂Nb₅Ol₅, NaBa₂Nb₅Ol₅, (Srl-x, Bax)Nb₂O₆ or Ba₂NaNb₅Ol₅ etc.. The bismuth layered ceramic is Bi4Ti3Ol2 or BaBi4Ti4Ol5 etc.. The layered perovskite-type ceramic is La₂Ti₂O₇-Sr₂Ta₂O₇, Na₂Ti₂O₇-Sr₂Ta₂O₇ or Ca₂Nb₂O₇-Sr₂Ta₂O₇ etc..

The pair of internal electrodes 15, 16 is disposed in parallel inside the piezoelectric ceramic 13 in the spaced relationship to each other. The pair of internal electrodes 15, 16 is oriented perpendicular to a direction of lamination of the plurality of piezoelectric element segments 12 (a direction of extension of the axis 11 of the laminated piezoelectric body 10). The internal electrode 15 is a positive electrode while the internal electrode 16 is a negative electrode. The internal electrode 15 will be hereinafter referred to as "internal positive electrode" while the internal electrode 16 will be hereinafter referred to as "internal negative electrode".

The internal positive electrode 15 is an electrode of Ag-Pb alloy. The internal positive electrode 15 inside the piezoelectric ceramic 13 is disposed closer to the lower contact portion 28 in such a manner as to intersect the axis 11 of the laminated piezoelectric body 10. Since the internal positive electrode 15 is disposed in such a manner as to intersect the axis 11 of the laminated piezoelectric body 10, the internal positive electrode 15 is disposed in parallel to the lower contact portion 28. The internal positive electrode 15 has a proximal end portion 15a exposed to the right sidewall 25 of the piezoelectric ceramic 13 and connected to the external electrode 17.

The internal negative electrode 16 is an electrode of Ag-Pb alloy similarly to the internal positive electrode 15. The internal negative electrode 16 inside the piezoelectric ceramic 13 is disposed closer to the upper contact portion 29 in such a manner as to intersect the axis 11 of the laminated piezoelectric body 10. Since the internal negative electrode 16 is disposed in such a manner as to intersect the axis 11 of the laminated piezoelectric body 10, the internal negative electrode 16 is disposed in parallel to the lower contact portion 28. The internal negative electrode 16 has a proximal end portion 16a exposed to the left sidewall 24 of the piezoelectric ceramic 13 and connected to the external electrode 18.

Although materials of the internal positive electrode 15 and the internal negative electrode 16 are Ag-Pb alloy in example 1 the materials are not limited to Ag-Pb alloy. For example, the materials of the internal positive electrode 15 and the internal negative electrode 16 may be Ag, Pt, Ni, Cu, Pd or Au, or alloy containing these elements.

The external electrode 17 is a positive electrode connected to the proximal end portion 15a of the internal positive electrode 15 while the external electrode 18 is a negative electrode connected to the proximal end portion 16a of the internal negative electrode 16. The external electrode 17 will be hereinafter referred to as an "external positive electrode" and the external electrode 17 will be hereinafter referred to as an "external negative electrode".

The external positive electrode 17 is an electrode made of Fe-Ni alloy. The external positive electrode 17 is connected to the proximal end portion 15a of the internal positive electrode 15 and is disposed on the right sidewall 25 of the piezoelectric ceramic 13. The external positive electrode 17 is disposed in such a manner as to intersect the internal positive electrode 15. The external positive electrode 17 is connected to a positive pole of a power supply 38 (Fig. 1) through a lead wire 36.

The external negative electrode 18 is an electrode made of Fe-Ni alloy. The external negative electrode 18 is connected to the proximal end portion 16a of the internal negative electrode 16 and is disposed on the left sidewall 24 of the piezoelectric ceramic 13. The external negative electrode 18 is disposed in such a manner as to intersect the internal negative electrode 16. The external negative electrode 18 is connected to a negative pole of the power supply 38 through a lead wire 37.

Although materials of the external positive electrode 17 and the external negative electrode 18 are Fe-Ni alloy in example 1, the materials are not limited to Fe-Ni alloy. For example, the materials of the external positive electrode 17 and the external negative electrode 18 are Ag, Pt, Ni, Cu, Pd, Au or alloy containing these elements.

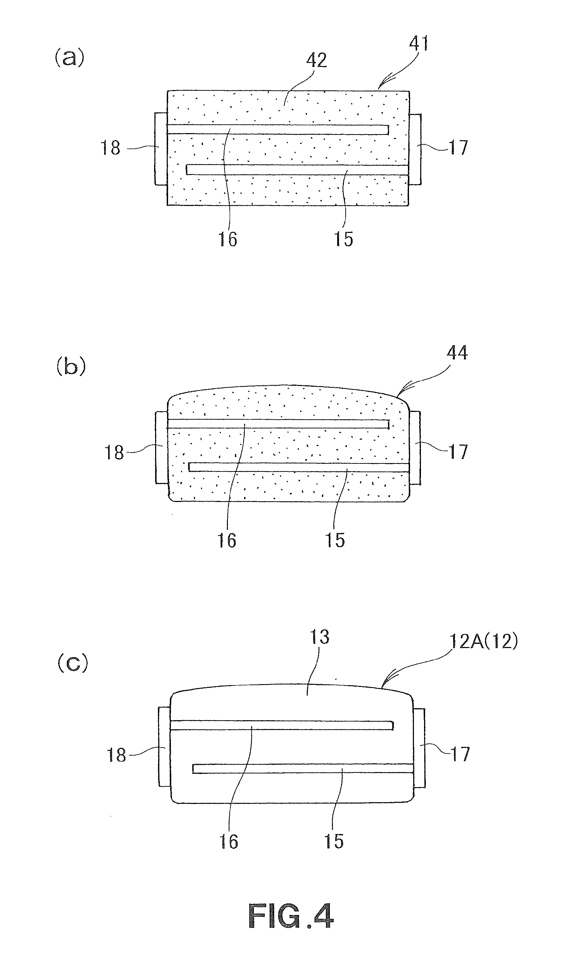

Discussion will be made with reference to Fig. 4 as to subjecting the piezoelectric ceramic 13 of the piezoelectric element segment 12A to barrel finishing. An unworked piezoelectric element segment 41 of 1,000 (1K) g shown in Fig. 4(a) is placed in a vessel made from polyethylene.

The unworked piezoelectric element segment 41 includes an unworked piezoelectric ceramic 42, a pair of internal electrodes 15, 16 and a pair of external electrodes 17, 18. The polyethylene vessel has a capacity of 10L (1 X 10 -2 m3). 1,200 (1.2 K) g of Zr balls (zirconium balls) each having a diameter of 5 mm serving as media (grinding materials) are placed in the polyethylene vessel. In addition, a 1 L (1 X 10-3m3) of pure water serving as solvent is poured into the vessel.

The polyethylene vessel containing the unworked piezoelectric element segment 41, the Zr balls and the solvent are rotated by a ball mill rotator. The polyethylene vessel is rotated at a speed of 85 rmp for 240 minutes. The rotation of the polyethylene vessel works the piezoelectric ceramic 42 to thereby a worked piezoelectric element segment 44 shown in Fig. 4(b).

The worked piezoelectric element segment 44 is then fired to provide a piezoelectric ceramic 13 (i.e., a piezoelectric element segment 12A) shown in Fig. 4(c).

Although the piezoelectric element segment 12A is provided by barrel finishing in example 1, the piezoelectric element segment 12A may be provided by machining, i.e., lathing or milling using a milling cutter or an end mill.

As shown in Fig. 1, the piezoelectric element segment 12A adheres to or is joined through the adhesive agent 21 to the upper piezoelectric element segment 12B and the lower piezoelectric element segment 12C.

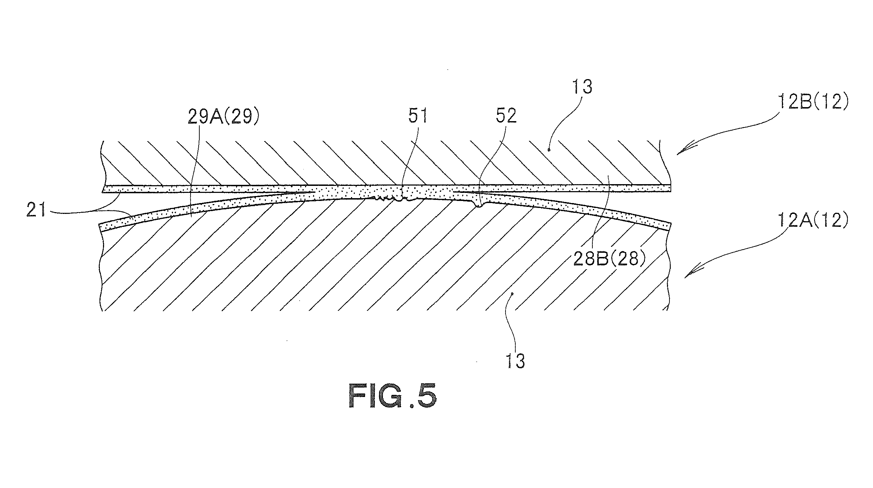

Discussion will be made with reference to Fig. 2 and Fig. 5 as to joining the upper contact portion 29A of the piezoelectric element segment 12A to the lower contact portion 28B of the upper piezoelectric element segment 12B.

As shown in Fig. 2 and Fig. 5, the adhesive agent 21 is a film of resin thinly applied to the upper contact portion 29A of the piezoelectric element segment 12A and the lower contact portion 28B of the upper piezoelectric element segment 12B for joining the upper contact portion 29A and the lower contact portion 28B together.

A resin used as the adhesive agent 21 has a high insulating capability and can harden in the range of normal temperature to 200 degrees Celsius. More specifically, silicone-based resin, epoxy-based resin or acryl-based resin is preferable because these resins have high insulating capability and are easy to use as a filler. In example 1, EPOCH 353ND available from Epoxy Technology Inc. is used as epoxy-based resin.

In joining the upper contact portion 29A and the lower contact portion 28B together by the adhesive agent 21, a coating film of the adhesive agent 21 is made thin and the film is formed preferably by dipping, printing, applying and dropping of the adhesive agent 21. In example 1, the adhesive agent 21 is dropped onto the upper contact portion 29A and the lower contact portion 28B.

More specifically, a syringe of a dispenser is filled with the adhesive agent 21. The syringe has a capacity of 3 to 50 cc [(3 ~50) X 10-6m3]. The adhesive agent 21 filling the syringe is forced out under an air pressure of 1 to 50 Psi [(1 to 50) X 6895 Pa] to thereby drop onto the upper contact portion 29A and the lower contact portion 28B. By thus dropping onto the upper contact portion 29A and the lower contact portion 28B, the adhesive agent 21 is applied thereto.

After the adhesive agent 21 is applied to the upper contact portion 29A and the lower contact portion 28B, the left and right sidewalls 24, 25 and the front and rear sidewalls 26, 27 of the piezoelectric element segment 12A and the upper piezoelectric element segment 12B are retained by a guide member (now shown). The piezoelectric element segment 12A and the upper piezoelectric element segment 12B are laminated together. The laminated segments 12A, 12B are held with a pressure or force of 10 to 500 N applied thereto in a direction of the lamination at a temperature of 100 to 200 degrees Celsius for 10 to 60 minutes. By holding the segments 12A, 12B for 10 to 60 minutes, the adhesive agent 21 hardens to thereby join the piezoelectric element segment 12A and the upper piezoelectric element segment 12B together.

Although the piezoelectric element segment 12A adheres to the upper piezoelectric element segment 12B in example 1, the plurality of laminated piezoelectric bodies 10 can adhere to one another in the same manner.

Since the upper contact portion 29A of the piezoelectric element segment 12A and the lower contact portion 28B of the upper piezoelectric element segment 12B are joined together using the adhesive agent 21, it becomes possible to prevent the upper contact portion 29A and the lower contact portion 28B from being displaced in a direction intersecting the direction of the lamination. That is, the plurality of laminated piezoelectric element segments 12 can be held on the axis 11 of the piezoelectric body 10. Therefore, it becomes possible to, for example, efficiently transmit a load from the lower contact portion 28 to the upper contact portion 29 to thereby enhance reliability of the laminated piezoelectric body 10.

Since the upper contact portion 29A and the lower contact portion 28B are joined together by the adhesive agent 21, a rough surface 51 or a recess 52 of the upper contact portion 29A, if any, can be filled with the adhesive agent 21 to ensure a smooth surface of the upper contact portion 29A, such that the lower contact portion 28B can be easily disposed (laminated) in place on the upper contact portion 29A. It thus becomes possible to, for example, efficiently transmit a load from the upper contact portion 29A to the lower contact portion 28B to thereby further enhance reliability of the laminated piezoelectric body 10.

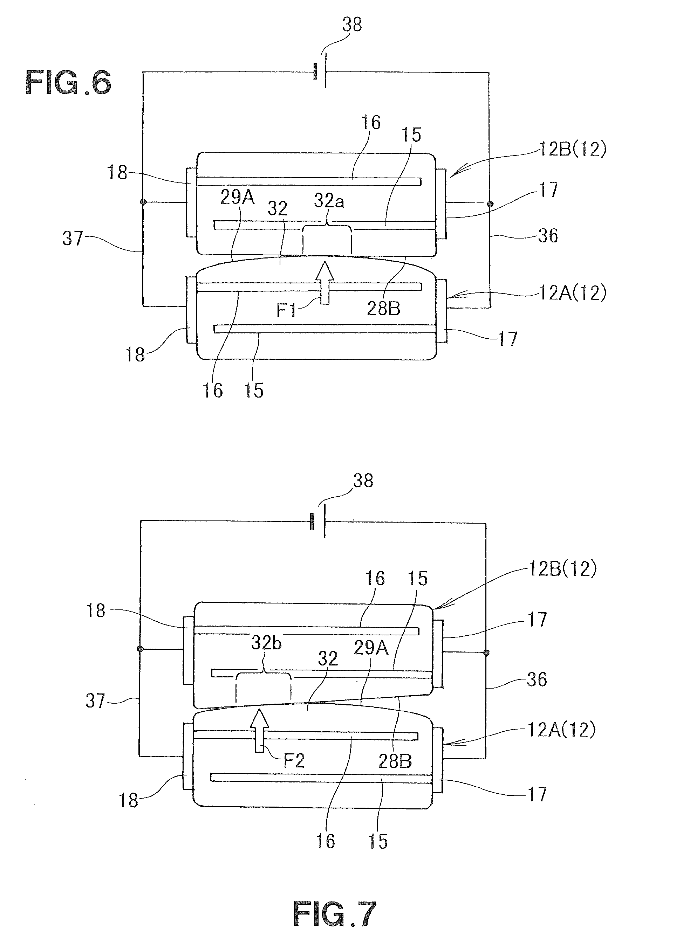

Discussion will be made with reference to Fig. 6 and Fig. 7 as to transmission of a load from the piezoelectric element segment 12A to the upper piezoelectric element segment 12B. It is noted that the adhesive agent 21 is not shown in Fig. 6 and Fig. 7 to facilitate understanding structures shown in Fig. 6 and Fig. 7.

First, reference is made to Fig. 6 showing the upper piezoelectric element segment 12B having the lower contact portion 28B extending horizontally. As shown in Fig. 6, a voltage is applied from the power supply 38 to the internal positive electrode 15 and the internal negative electrode 16 of the piezoelectric element segment 12A while a voltage is applied from the power supply 38 to the internal positive electrode 15 and the internal negative electrode 16 of the upper piezoelectric element segment 12B. As a result, the central projection 32 of the piezoelectric element segment 12A applies a load F1 to the lower contact portion 28B of the upper piezoelectric element segment 12B.

The central projection 32 of the piezoelectric element segment 12A has the relatively large area 32a contacting the lower contact portion 28B of the upper piezoelectric element segment 12B. Since the relatively large area 32a contacts the center of the lower contact portion 28B, the load F1 applied from the central projection 32 to the lower contact portion 28B can be dispersed to the lower contact portion 28B in a preferred manner.

As a result, it becomes possible to prevent more load than necessary from being applied to the lower contact portion 28B, thereby enhancing durability of the upper piezoelectric element segment 12B. The enhancement of the durability of the upper piezoelectric element segment 12B enhances durability of the laminated piezoelectric body 10.

Next, reference is made to Fig. 7 showing the upper piezoelectric element segment 12B having the lower contact portion 28B slanting. As shown in Fig. 7, a voltage is applied from the power supply 38 to the internal positive electrode 15 and the internal negative electrode 16 of the piezoelectric element segment 12A while a voltage is applied from the power supply 38 to the internal positive electrode 15 and the internal negative electrode 16 of the upper piezoelectric element segment 12B. As a result, the central projection 32 of the piezoelectric element segment 12A applies a load F2 to the lower contact portion 28B of the upper piezoelectric element segment 12B.

The central projection 32 of the piezoelectric element segment 12A has the relatively large area 32b contacting the lower contact portion 28B of the upper piezoelectric element segment 12B. Since the relatively large area 32b contacts the center (i.e., a part other than corners) of the lower contact portion 28B, the load F2 applied from the central projection 32 to the lower contact portion 28B can be dispersed to the lower contact portion 28B in a preferred manner.

As a result, it becomes possible to prevent more load than necessary from being applied to the lower contact portion 28B, thereby enhancing durability of the upper piezoelectric element segment 12B. The enhancement of the durability of the upper piezoelectric element segment 12B enhances durability of the laminated piezoelectric body 10.

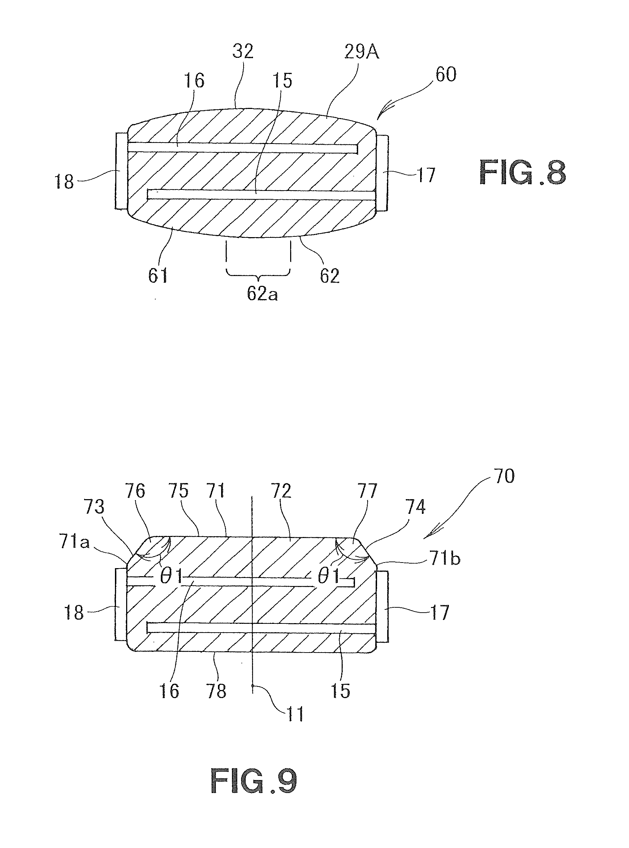

Modifications 1 to 4 to the embodiment 1 will be discussed with reference to Fig. 8 to Fig. 13. In the modifications 1 to 4, parts corresponding to those of the laminated piezoelectric body 10 are designated by the same or like reference numerals and discussion of the parts will be omitted. It is noted that the adhesive agent 21 is not shown in Fig. 8 to Fig. 13 to facilitate understanding structures shown in Fig. 8 to Fig. 13.

### (Modification 1)

As shown in Fig. 8, a piezoelectric element segment 60 in the modification 1 has the same structure as that of the piezoelectric element segment 12A in example 1 except that the segment 60 includes a lower contact portion 61 in place of the lower contact portion 28A of the piezoelectric ceramic 13 in example 1.

The lower contact portion 61 has a convex shape protruding downwardly to form a central projection 62 at a center thereof. The central projection 62 is located below the central projection 32 in example 1 in symmetrical relationship thereto. The central projection 62, which is formed at the center of the lower contact portion 61, protrudes toward the center of the upper contact portion 29C of the lower piezoelectric element segment 12C.

The lower contact portion 61 protrudes downwardly in the form of a convexity curved to such a degree that the central projection 62 is relatively flat to contact the lower contact portion 28 of the upper piezoelectric element segment 12B along a relatively large area 62a thereof.

### (Modification 2)

As shown in Fig. 9, a piezoelectric element segment 70 in the modification 2 has the same structure as that of the piezoelectric element segment 12A in example 1 except that the segment 70 includes an upper contact portion 71 in place of the lower contact portion 29A of the piezoelectric ceramic 13 in example 1.

The upper contact portion 71 has a generally trapezoidal shape protruding upwardly to form a central projection 72 at a center thereof. The central projection 72 has a left slanting surface (a slanting surface) 73 extending in the form of an upward slope from a left end portion 71a of the upper contact portion 71 toward the axis 11, a right slanting surface (a slanting surface) 74 extending in the form of an upward slope from a right end portion 71b of the upper contact portion 71 toward the axis 11, and a flat surface 75 horizontally extending between upper ends of the left and right slanting surfaces 73, 74.

The central projection 72 has a left intersection 76 at which the left slanting surface 73 and the flat surface 75 meet each other, and a right intersection 77 at which the right slanting surface 74 and the flat surface 75 meet each other. The left intersection 76 and the right intersection 77 each have an obtuse angle *θ* 1.

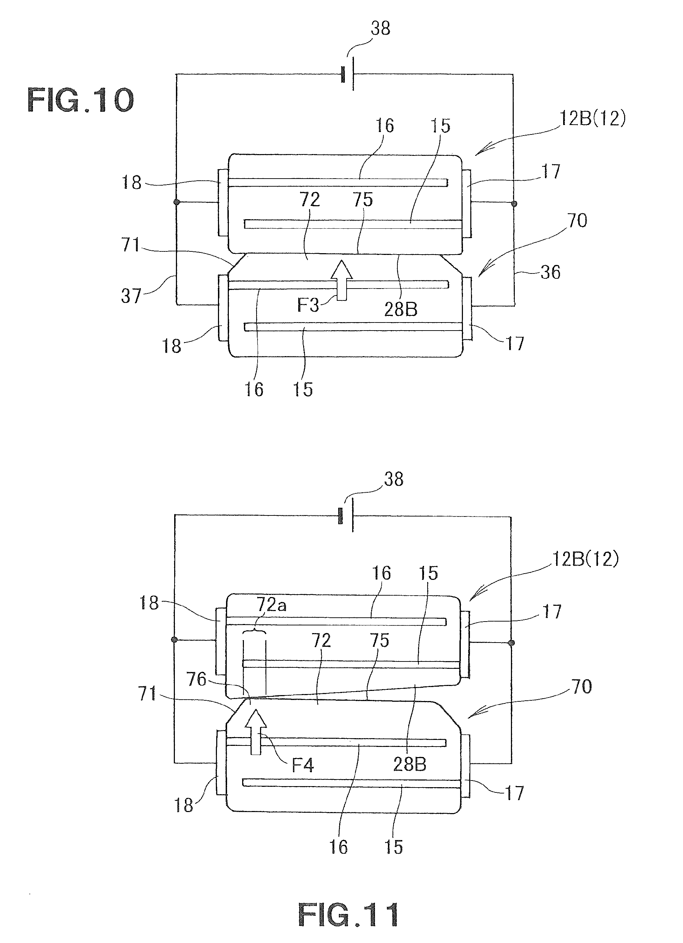

As shown in Fig. 10, the central projection 72, which is formed at the center of the upper contact portion 71, protrudes toward the lower contact portion 28B of the upper piezoelectric element segment 12B. The upper contact portion 71 protrudes upwardly in the form of a generally trapezoid to form the central projection 72 having the flat surface 75 at a top thereof. Thus, the flat surface 75 of the central projection 72 contacts the center of the lower contact portion 28B along a relatively large contact area thereof.

Thus, a load F3 applied from the central projection 72 to the center of the lower contact surface 28B can be dispersed to the lower contact portion 28B in a preferred manner. Therefore, it becomes possible to prevent more load than necessary from being applied to the lower contact portion 28B, thereby enhancing durability of the upper piezoelectric element segment 12B.

As shown in Fig. 11, the lower contact portion 28B of the upper piezoelectric element segment 12B may slant, in which case the left intersection 76 of the central projection 72 of the piezoelectric element segment 70 contacts the center (i.e., a part other than corners) of the lower contact portion 28B. Since the left intersection 76 has the obtuse angle *θ* 1 (Fig. 9), the central projection 72 of the piezoelectric element segment 70 contacts the lower contact portion 28B of the upper piezoelectric element segment 12B along a relatively large area 72a thereof.

In this state, a load F4 is applied from the central projection 72 of the piezoelectric element segment 70 to the lower contact portion 28B of the upper piezoelectric element segment 12B. Since the left intersection 76 contacts the lower contact portion 28B along the relatively large area 72a, the load F4 applied from the left intersection 76 to the lower contact portion 28B can be dispersed to the lower contact portion 28B in a preferred manner. Therefore, it becomes possible to prevent more load than necessary from being applied to the lower contact portion 28B, thereby enhancing durability of the upper piezoelectric element segment.

As shown in Fig. 9, the central projection 72 can be formed on the upper contact portion 71 without increasing working accuracy more than necessary in grinding the upper contact portion 71. In other words, it becomes possible to increase a yield rate in grinding the upper contact portion 71 as well as to facilitate a grinding (working) operation on the upper contact portion 71, thereby ensuring productivity of the piezoelectric element segment 12A.

The left and right slanting surfaces 73, 74 and the flat surface 75 form the generally trapezoidal shape of the central projection 72. Each of the left and right slanting surfaces 73, 74 (i.e., the central projection 72 of the generally trapezoidal shape) has a relatively simple configuration. In other words, the central projection 72 is easy to form, thereby ensuring productivity of the piezoelectric element segment 70.

### (Modification 3)

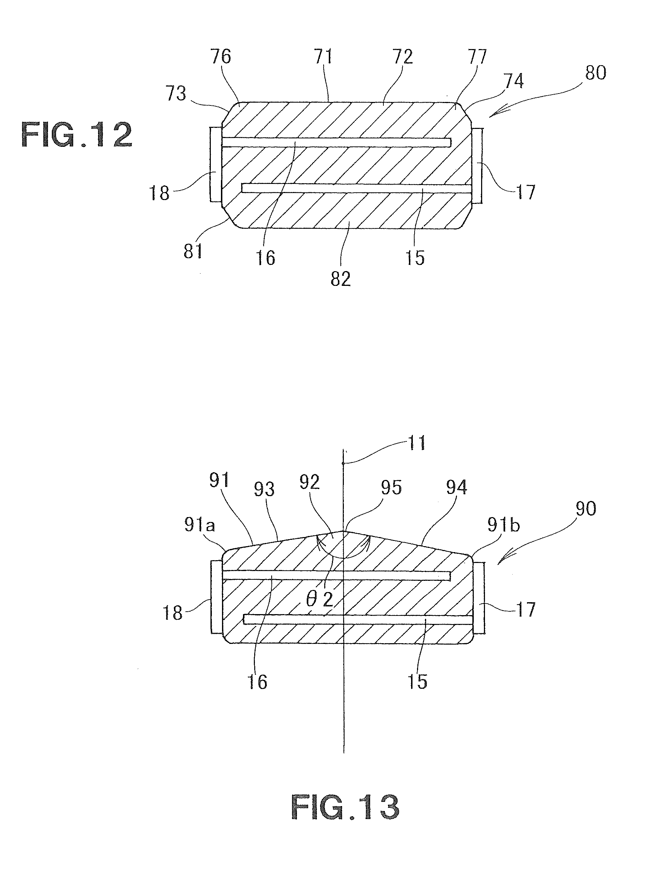

As shown in Fig. 12, a piezoelectric element segment 80 in the modification 3 has the same structure as that of the piezoelectric element segment 70 in the modification 2 except that the segment 80 includes a lower contact portion 81 in place of the lower contact portion 78 of the piezoelectric element segment 70 in the modification 2. The lower contact portion 78 of the piezoelectric element segment 70 is flat as is the lower contact portion 28A in example 1.

The lower contact portion 81 of the piezoelectric element segment 80 has a generally trapezoidal shape protruding downwardly to form a central projection 82 at a center thereof. The central projection 82 is located below the central projection 72 in the modification 2 in symmetrical relationship thereto. The central projection 82, which is formed at the center of the lower contact portion 81, protrudes toward the center of the upper contact portion 29C (Fig. 1) of the lower piezoelectric element segment 12C.

The lower contact portion 81 protrudes downwardly in the form of the general trapezoid to such a degree that the central projection 82 is relatively flat to contact the upper contact portion 29C (Fig. 1) of the lower piezoelectric element segment 12C along a relatively large area thereof, as in the central projection 72 of the upper contact portion 71.

### (Modification 4)

As shown in Fig. 13, a piezoelectric element segment 90 in the modification 4 being an embodiment of the present invention has the same structure as that of the piezoelectric element segment 12A in example 1 except that the segment 90 includes an upper contact portion 91 in place of the upper contact portion 29A of the piezoelectric ceramic 13 in example 1.

The upper contact portion 91 has a generally triangle shape protruding upwardly to form a central projection 92 at a center thereof. The central projection 92 has a left slanting surface (a slanting surface) 93 extending in the form of an upward slope from a left end portion 91a of the upper contact portion 91 toward the axis 11, and a right slanting surface (a slanting surface) 94 extending in the form of an upward slope from a right end portion 91b of the upper contact portion 91 toward the axis 11.

The central projection 92 has an intersection 95 at which the left slanting surface 93 and the right slanting surface 94 meet each other. The intersection 95 has an obtuse angle *θ* 2.

The central projection 92, which is formed at the center of the upper contact portion 91, protrudes toward the lower contact portion 28B (Fig. 1) of the upper piezoelectric element segment 12B. The upper contact portion 92 has the intersection 95 formed at the obtuse angle *θ* 2. Thus, the intersection 95 of the central projection 92 contacts the center of the lower contact portion 28B along a relatively large contact area thereof.

Thus, a load applied from the central projection 92 (more specifically the intersection 95) to the center of the lower contact surface 28B can be dispersed to the lower contact portion 28B in a preferred manner. Therefore, it becomes possible to prevent more load than necessary from being applied to the lower contact portion 28B, thereby enhancing durability of the upper piezoelectric element segment 12B.

Even where the lower contact portion 28B of the upper piezoelectric element segment 12B may slant, the intersection 95 contacts the center of the lower contact portion 28B. The intersection 95 is formed at the obtuse angle *θ* 2. The intersection 95 contacts the lower contact portion 28B of the upper piezoelectric element segment 12B along a relatively large area thereof.

Thus, a load applied from the intersection 95 to the lower contact portion 28B of the upper piezoelectric element segment 12B can be dispersed to the lower contact portion 28B in a preferred manner. Therefore, it becomes possible to prevent more load than necessary from being applied to the lower contact portion 28B, thereby enhancing durability of the upper piezoelectric element segment.

Further, the central projection 92 of the piezoelectric element segment 90 can be formed on the upper contact portion 91 without increasing working accuracy more than necessary in grinding the upper contact portion 91. In other words, it becomes possible to increase a yield rate in grinding the upper contact portion 91 as well as to facilitate a grinding (working) operation on the upper contact portion 91, thereby ensuring productivity of the piezoelectric element segment 12A.

The left and right slanting surfaces 93, 94 form the generally triangular shape of the central projection 92. Each of the left and right slanting surfaces 93, 94 (i.e., the central projection 92 of the generally triangular shape) has a relatively simple configuration. In other words, the central projection 92 is easy to form, thereby ensuring productivity of the piezoelectric element segment 90.

### Example 2

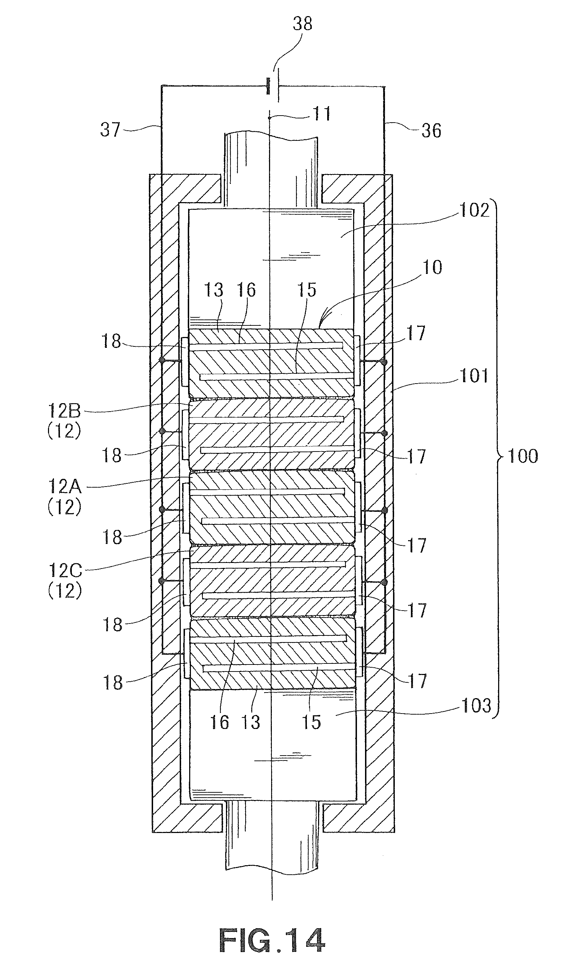

A laminated piezoelectric body 100 in the second example 2 will be discussed with reference to Fig. 14. Parts of the laminated piezoelectric body 100 corresponding to those of the laminated piezoelectric body 10 in the first example 1 are designated by the same reference numerals.

As shown in Fig. 14, the laminated piezoelectric body 100 includes the laminated piezoelectric body 10 housed in a guide member 101 and supported by upper and lower fasteners 102, 103.

As for the laminated piezoelectric body 100 in the second example 2, the laminated piezoelectric body 10 is housed in the guide member 101. The guide member 101 allows the external positive electrode 17 and the external negative electrode 18 and the front and rear sidewalls 26, 27 (Fig. 3) of the piezoelectric element segment 12 to move along the axis 11.

The guide member 101 prevents the external positive electrode 17 and the external negative electrode 18 and the front and rear sidewalls 26, 27 from moving in a direction intersecting the axis 11, thereby preventing the plurality of piezoelectric element segments 12 from moving in the direction intersecting the axis 11. Thus, it becomes possible to better hold the plurality of laminated piezoelectric element segments 12 on the axis 11, thereby better enhancing reliability of the laminated piezoelectric body 100.

The laminated piezoelectric body according to the present disclosure is not limited to those in the foregoing examples and embodiment but may be appropriately changed or improved. For example, the upper contact portion 29A may have a spherical shape although it has a convex shape forming the central projection 32 thereon in examples 1 and 2.

The piezoelectric element segment 12 may have a plurality of pairs of internal electrodes although it has the one pair of internal electrodes 15, 16 in examples 1 and 2. By the term "plurality of pairs of internal electrodes", it is meant that one pair of internal electrodes is provided in plural. For example, the term "two pairs of internal electrodes", it is meant that one pair of internal electrodes is provided in two.

Although the external positive electrode 17 is connected directly to the internal positive electrode 15 in examples 1 and 2, the external positive electrode 17 may be connected to the internal positive electrode 15 through an electrically conductive intermediate member disposed on the right sidewall 25. Interposition of the intermediate member between the right sidewall 25 and the external positive electrode 17 makes it possible for the intermediate member to reduce or eliminate adverse effect resulting from difference in linear expansion coefficient between the right sidewall 25 (piezoelectric ceramic 13) and the external positive electrode 17.

Similarly, although the external negative electrode 18 has been described as being connected directly to the internal negative electrode 16, the external negative electrode 18 may be connected to the internal negative electrode 16 through an electrically conductive intermediate member disposed on the left sidewall 24. Interposition of the intermediate member between the left sidewall 24 and the external negative electrode 18 makes it possible for the intermediate member to reduce or eliminate adverse effect resulting from difference in linear expansion coefficient between the left sidewall 24 (piezoelectric ceramic 13) and the external negative electrode 18.

The laminated piezoelectric body, the piezoelectric element segment, the piezoelectric ceramic, the internal positive electrode, the internal negative electrode, the adhesive agent, the lower contact portion, the upper contact portion, the central projection, the curved and left and right slanting surfaces in examples 1 and 2 have configurations or structures which are not limited to those discussed above but may be appropriately changed.

### INDUSTRIAL APPLICABILITY

The present invention is suitable for use as a laminated piezoelectric body including a plurality of laminated piezoelectric element segments each including a piezoelectric ceramic having internal electrodes therein.

### Reference Signs List:

10, 100...laminated piezoelectric bodies, 12, 12A, 60, 70, 80, 90...piezoelectric element segments, 12B... an upper piezoelectric element segment, 12C... a lower piezoelectric element segment, 13... a piezoelectric ceramic, 15... an internal positive electrode (one of a pair of internal electrodes), 16... an internal negative electrode (an opposite one of the pair of internal electrodes), 21... an adhesive agent, 28, 28B...lower contact portions (opposite ones of contact portions), 29, 29A, 71, 91... upper contact portions (ones of the contact portions), 32, 62, 72, 82, 92...central projections, 33...a curved surface, 73, 93...left slanting surfaces (slanting surfaces), 74, 94... right slanting surfaces (slanting surfaces)

## Claims

1. A laminated piezoelectric body (10) having a plurality of piezoelectric element segments (12) laminated on one another, each of the piezoelectric element segments comprising:
a piezoelectric ceramic (13); and
a pair of internal electrodes (15, 16) disposed in the piezoelectric ceramic in spaced relationship to each other,
wherein the internal electrodes (15, 16) are arranged in a direction of lamination of the plurality of piezoelectric element segments (12) in the spaced relationship to each other, the internal electrodes being oriented perpendicularly to the direction of lamination of the plurality of piezoelectric element segments,
wherein adjacent ones of the plurality of piezoelectric element segments (12) contact each other at contact portions (29A, 29B) thereof, and
**characterized in that** one of the contact portions of the adjacent piezoelectric element segments has a triangle-shaped central projection (32) protruding toward an opposite one of the contact portions.

2. The body of claim 1, wherein the contact portions of the adjacent piezoelectric element segments are joined together by an adhesive agent (21).

## Patentansprüche

1. Laminierter piezoelektrischer Körper (10), der eine Mehrzahl von Piezoelektrisches-Element-Segmente (12) aufweist, die aufeinander laminiert sind, wobei jedes der Piezoelektrisches-Element-Segmente aufweist:
eine piezoelektrische Keramik (13); und
ein Paar von internen Elektroden (15, 16), die in Abstandsbeziehung zueinander in der piezoelektrischen Keramik angeordnet sind,
wobei die internen Elektroden (15, 16) in einer Laminierungsrichtung der Mehrzahl von Piezoelektrisches-Element-Segmenten (12) in der Abstandsbeziehung zueinander angeordnet sind, wobei die internen Elektroden senkrecht zur Laminierungsrichtung der Mehrzahl von Piezoelektrisches-Element-Segmenten orientiert sind,
wobei benachbarte der Mehrzahl von Piezoelektrisches-Element-Segmenten (12) an ihren Kontaktabschnitten (29A, 29B) einander kontaktieren, und
**dadurch gekennzeichnet, dass** einer der Kontaktabschnitte der benachbarten Piezoelektrisches-Element-Segmente einen dreieckförmigen mittleren Vorsprung (32) aufweist, der zu einem entgegengesetzten der Kontaktabschnitte hin vorsteht.

2. Der Körper von Anspruch 1, wobei die Kontaktabschnitte der benachbarten Piezoelektrisches-Element-Segmente durch Klebstoff (21) miteinander verbunden sind.

## Revendications

1. Corps piézoélectrique stratifié (10) comportant une pluralité de segments d'éléments piézoélectriques (12) stratifiés les uns sur les autres, chacun des segments d'éléments piézoélectriques comprenant :
une céramique piézoélectrique (13) ; et
une paire d'électrodes internes (15, 16) disposée dans la céramique piézoélectrique en une relation espacée l'une de l'autre,
dans lequel les électrodes internes (15, 16) sont agencées dans une direction de stratification de la pluralité de segments d'éléments piézoélectriques (12) dans la relation espacée l'une de l'autre, les électrodes internes étant orientées perpendiculairement à la direction de stratification de la pluralité de segments d'éléments piézoélectriques,
dans lequel les segments adjacents de la pluralité de segments d'éléments piézoélectriques (12) entrent en contact les uns avec les autres au niveau de leurs portions de contact (29A, 29B), et
**caractérisé en ce que** l'une des portions de contact des segments d'éléments piézoélectriques adjacents comporte une saillie centrale en forme de triangle (32) faisant saillie vers une portion opposée parmi les portions de contact.

2. Corps selon la revendication 1, dans lequel les portions de contact des segments d'éléments piézoélectriques adjacents sont assemblées ensemble par un agent adhésif (21).
